# EUROPÄISCHE PATENTANMELDUNG

(11) **EP 4 567 652 A1**
(43) Veröffentlichungstag der Anmeldung: **11.06.2025**
(21) Anmeldenummer: 23214036.8
(22) Anmeldetag: 04.12.2023
(51) Int. Cl.: G06F 30/12, G06F 30/13, G06T 17/00, G06T 19/00

(54) **VERFAHREN UND VORRICHTUNG ZUM GENERIEREN EINES 3D-COMPUTERMODELLS EINES OBJEKTS AUS 3D-SCAN DATEN**

(71) Anmelder: Siemens Schweiz AG, 8047 Zürich (CH)
(72) Erfinder: EMIROGLU, Altug, 81541 Munich (DE); KLEIN, Wolfram, 85579 Neubilberg (DE); MAYER, Hermann Georg, 83209 Prien am Chiemsee (DE); PASCH, Theresa, 80799 München (DE)
(74) Vertreter: Siemens Patent Attorneys

(57) **Zusammenfassung**

Die Erfindung betrifft ein Verfahren zum Generieren eines 3D-Computermodells (3DCM) eines Objekts (OBJ) mit den Verfahrensschritten:
- Ausführen (S1a) eines 3D-Scans des Objekts (OB) mittels eines Scanners (101), wobei 3D-Daten (3DD) zur Erstellung einer 3D-Repräsentation des Objekts erfasst werden,
- Ausgeben (S1b) eines Objektelementidentifikators (OBJID) eines selektierten Objektelements (OBJE), wobei das Objektelement (OBJE) anhand eines vorgegebenen Objektelementmerkmals (OBJC) und während der Ausführung des 3D-Scans des Objekts selektiert wird,
- Identifizieren (S2) der 3D-Daten (3DD*) in der 3D-Repräsentation des selektierten Objektelements anhand des Objektelementidentifikators,
- Markieren (S3) der 3D-Daten in der 3D-Repräsentation des selektierten Objektelements mittels Eingabe eines Markierungsbefehls über eine Eingabeschnittstelle,
- Generieren (S4) eines 3D-Computermodells des Objekts aus den 3D-Daten des 3D-Scans unter Berücksichtigung der Markierung des selektierten Objektelements
und
- Ausgeben (S5) des 3D-Computermodells des Objekts.

## Beschreibung

Die Erfindung betrifft ein Verfahren und eine Vorrichtung zum Generieren eines 3D-Computermodells eines Objekts.

Das Einrichten einer Computersimulation in der sogenannten Engineering-Phase ist oft zeitaufwändig und verursacht im Vergleich zur eigentlichen computergestützten Simulation und zur Auswertung der Ergebnisse einen Großteil der Kosten. Beispielsweise kann der Aufwand für das Engineering bei einer computergestützten Personenstromsimulation bei einem Anteil von über 80% liegen. Eine Reduzierung dieses Aufwands ist demnach wünschenswert.

Bisher müssen Computersimulationen üblicherweise in einer spezifischen Engineering-Software eingerichtet werden. In vielen Fällen wird dabei ein CAD-Modell des zu simulierenden Objekts bzw. der zu simulierenden Umgebung in das Engineering-Programm geladen, bereinigt und mit simulationsspezifischen Elementen versehen. Im Fall der Personenstromsimulation kann dies beispielsweise ein CAD-Plan des Gebäudes sein. Aus diesem müssen beispielsweise zunächst alle Elemente entfernt werden, die für eine Simulation unnötig und/oder hinderlich sind (z.B. Bemaßungslinien, die fälschlich als Hindernisse aufgefasst werden könnten).

Es ist daher eine Aufgabe der Erfindung, die Generierung eines Computersimulationsmodells für ein Objekt zu vereinfachen.

Die Aufgabe wird durch die in den unabhängigen Ansprüchen beschriebenen Maßnahmen gelöst. In den abhängigen Ansprüchen sind vorteilhafte Weiterbildungen der Erfindung dargestellt. Gemäß einem ersten Aspekt betrifft die Erfindung ein Verfahren zum Generieren eines 3D-Computermodells eines Objekts mit den Verfahrensschritten:
- Ausführen eines 3D-Scans des Objekts mittels eines Scanners, wobei 3D-Daten zur Erstellung einer 3D-Repräsentation des Objekts erfasst werden,
- Ausgeben eines Objektelementidentifikators eines selektierten Objektelements, wobei das Objektelement anhand eines vorgegebenen Objektelementmerkmals und während der Ausführung des 3D-Scans des Objekts selektiert wird,
- Identifizieren der 3D-Daten in der 3D-Repräsentation des selektierten Objektelements anhand des Objektelementidentifikators,
- Markieren der 3D-Daten in der 3D-Repräsentation des selektierten Objektelements mittels Eingabe eines Markierungsbefehls über eine Eingabeschnittstelle,
- Generieren eines 3D-Computermodells des Objekts aus den 3D-Daten des 3D-Scans unter Berücksichtigung der Markierung des selektierten Objektelements
   und
- Ausgeben des 3D-Computermodells des Objekts.

Gemäß einem zweiten Aspekt betrifft die Erfindung eine Vorrichtung zum Generieren eines 3D-Computermodells eines Objekts, wobei die Vorrichtung folgende Einheiten umfasst:
- einen Scanner, der derart eingerichtet ist, einen 3D-Scan des Objekts auszuführen, wobei 3D-Daten zur Erstellung einer 3D-Repräsentation des Objekts erfasst werden,
- eine Selektionseinheit, die derart eingerichtet ist, einen Objektelementidentifikator (OBJID) eines selektierten Objektelements (OBJE) auszugeben, wobei das Objektelement (OBJE) anhand eines vorgegebenen Objektelementmerkmals (OBJC) und während der Ausführung des 3D-Scans des Objekts selektiert wird,
- eine Eingabeschnittstelle, die derart eingerichtet ist, die 3D-Daten in der 3D-Repräsentation des selektierten Objektelements anhand des Objektelementidentifikators zu identifizieren und mittels Eingabe eines Markierungsbefehls zu markieren,

- einen Modellgenerator, der derart eingerichtet ist, ein 3D-Computermodell des Objekts anhand des 3D-Scans unter Berücksichtigung der Markierung des selektierten Objektelements zu generieren,
   und
- eine Ausgabeeinheit, die derart eingerichtet ist, das 3D-Computermodell des Objekts auszugeben.

Unter einem "3D-Computermodell" kann insbesondere ein Modell für eine computergestützte Simulation auf Basis dreidimensionaler Daten verstanden werden.

Unter einem "Objekt" kann insbesondere ein technisches System, wie z.B. ein Gerät oder technische Anlage/Fabrikanlage, oder ein Gebäude oder Raum verstanden werden. Ein "Objektelement" kann demnach ein Element oder eine Komponente dieses Objekts, wie z.B. eine Komponente eines Geräts oder ein Teil/Teilbereich oder Gegenstand eines Gebäudes sein. Ein "Objektelementmerkmal" kann beispielsweise ein Merkmal oder eine Eigenschaft eines Objekts in einem Gebäude sein. Ein "Objektelementidentifikator" kann insbesondere mit dem Objektelementmerkmal verknüpft bzw. von diesem abhängig sein.

Unter einem "Markierungsbefehl" kann beispielsweise eine Eingabe über eine Schnittstelle oder Steuerungseinheit verstanden werden, die dazu dient, das Objektelement in der 3D-Repräsentation zu markieren. Unter einer "Markierung" kann insbesondere eine Hervorhebung, wie z.B. farblich, oder eine spezielle Bearbeitung, wie z.B. (Zwischen-)Speicherung, der entsprechenden 3D-Daten verstanden werden.

Es ist ein Vorteil der vorliegenden Erfindung, dass Eigenschaften eines zu generierenden 3D-Computermodells für ein Objekt schon während eines Scan-Vorgangs zur Erfassung von 3D-Daten/dreidimensionalen Daten des real existierenden Objekts angelegt werden können, d.h. insbesondere zeitgleich und vor Ort. Somit ist insbesondere kein CAD-Modell des Objekts nötig, welches für die Generierung eines Computermodells erst aufwendig bearbeitet werden müsste.

In einer Ausführungsform der Erfindung kann die Markierung des selektierten Objektelements bei der Generierung des 3D-Computermodells berücksichtigt werden, indem die 3D-Daten der 3D-Repräsentation des selektierten Objektelements bei der Generierung des 3D-Computermodells gelöscht werden.

Somit werden lediglich diejenigen 3D-Daten bei der Generierung des 3D-Computermodells berücksichtigt, die nicht markiert sind. In anderen Worten, die markierten 3D-Daten werden vorzugsweise gelöscht, bevor das 3D-Modell aus den übrigen 3D-Daten erstellt wird.

In einer alternativen Ausführungsform der Erfindung kann die Markierung des selektierten Objektelements bei der Generierung des 3D-Computermodells berücksichtigt werden, indem die 3D-Daten der 3D-Repräsentation des selektierten Objektelements bei der Generierung des 3D-Computermodells für eine nachgelagerte Computersimulation des Objekts gekennzeichnet werden.

So können beispielsweise 3D-Daten gekennzeichnet werden, die in einer nachgelagerten Computersimulation als Startpunkte, Randbedingungen, etc. dienen können.

In einer weiteren Ausführungsform der Erfindung kann das Markieren der 3D-Daten in der 3D-Repräsentation des selektierten Objektelements das Speichern einer dem selektierten Objektelement zugeordneten Objektelementinformation umfassen.

Somit kann zu den 3D-Daten beispielsweise eine Eigenschaft des Objektelements und/oder eine für eine nachgelagerte Computersimulation erforderliche Information über die 3D-Daten hinterlegt bzw. gespeichert werden. Dies kann beispielsweise über einen entsprechenden Link erfolgen, der mit den 3D-Daten verknüpft ist.

In einer weiteren Ausführungsform der Erfindung kann sich das Objektelementmerkmal auf eine vorgegebene Anforderung an das Objektelement für eine dem 3D-Scan nachgelagerte Computersimulation des Objekts beziehen.

Beispielsweise kann somit ein Objektelement selektiert werden, das diese Anforderung erfüllt. Beispielsweise können in einem 3D-Scan eines Bauwerks alle Flächen, die die Anforderung "betretbar" erfüllen, selektiert werden.

In einer weiteren Ausführungsform der Erfindung kann das Objektelementmerkmal sich auf eine vorgegebene Funktion des Objektelements beziehen.

Somit kann ein Objektelement anhand seiner Funktion selektiert werden.

In einer weiteren Ausführungsform der Erfindung kann der Objektelementidentifikator eine Positionsinformation des Objektelements umfassen.

Dies ermöglicht eine einfache Lokalisierung bzw. Identifikation der entsprechenden 3D-Daten des Objektelements. Eine Positionsinformation kann beispielsweise eine GPS-Position sein.

In einer weiteren Ausführungsform der Erfindung kann eine Computersimulation des Objekts auf Basis des 3D-Computermodells ausgeführt werden.

Insbesondere liegt das 3D-Computermodell bereits in geeigneter Form vor, um daraus eine Computersimulation zu starten.

In einer weiteren Ausführungsform der Erfindung kann das Objekt ein Gebäude und die nachgelagerte Computersimulation eine Personenstromsimulation sein.

Ausführungsbeispiele des erfindungsgemäßen Verfahrens und der erfindungsgemäßen Vorrichtung sind in den Zeichnungen beispielhaft dargestellt und werden anhand der nachfolgenden Beschreibung näher erläutert. Es zeigen:
- Fig. 1:: ein Ausführungsbeispiel eines Verfahrens zum Generieren eines 3D-Computermodells eines Objekts;
- Fig. 2:: ein Ausführungsbeispiel einer Vorrichtung zum Generieren eines 3D-Computermodells eines Objekts; und
- Fig. 3:: ein weiters Ausführungsbeispiel eines Verfahrens zum Generieren eines 3D-Computermodells eines Objekts.

Einander entsprechende Teile sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

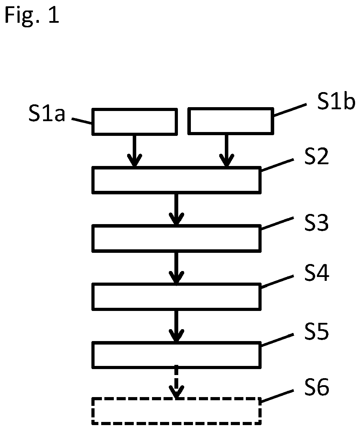

Figur 1 zeigt ein Ausführungsbeispiel eines Verfahrens zum Generieren eines 3D-Computermodells eines Objekts. Das Objekt kann beispielsweise ein Gebäude sein. Das 3D-Computermodell des Gebäudes kann nachgelagert beispielsweise für eine computergestützte Personenstromsimulation für dieses Gebäude genutzt werden.

Das Verfahren umfasst folgende Verfahrensschritte:
In einem ersten Verfahrensschritt S1a wird ein 3D-Scan/ein Scan in drei Dimensionen des Objekts mittels eines Scanners ausgeführt. Dabei werden 3D-Daten/dreidimensionale Daten zur Erstellung einer 3D-Repräsentation des Objekts erfasst. Aus den 3D-Daten wird anschließend eine 3D-Repräsentation des Objekts erstellt.

Während der Ausführung des 3D-Scans, d.h. vorzugsweise parallel bzw. nahezu zeitgleich, wird in einem weiteren Verfahrensschritt S1b ein Objektelementidentifikator eines anhand eines vorgegebenen Objektelementmerkmals selektierten Objektelements des real existierenden Objekts ausgegeben.

Das Objektelementmerkmal kann sich beispielsweise auf eine Funktion des Objektelements beziehen, wie z.B. alle Durchgänge in dem Gebäude. Es ist auch möglich, dass das Objektelementmerkmal sich auf eine Anforderung an das Objektelement für eine nachgelagerte Computersimulation bezieht, wie z.B. alle Orte/Punkte des Gebäudes, die für eine nachgelagerte Personenstromsimulation als Startpunkte für Personenbewegungen genutzt werden sollen. Alternativ kann ein Gegenstand oder ein Teilbereich des Gebäudes anhand einer Eigenschaft selektiert werden.

Der Objektelementidentifikator kann beispielsweise eine Bezeichnung des Gegenstands (z.B. "Tür A" oder "Schrank B") oder des Teilbereichs (z.B. "Raum 1") sein. Der Objektelementidentifikator kann außerdem beispielsweise eine Positionsinformation des Objektelements umfassen, wie z.B. GPS-Ortsdaten.

Im nächsten Verfahrensschritt S2 werden die 3D-Daten des selektierten Objektelements in der 3D-Repräsentation des Objekts anhand des Objektelementidentifikators identifiziert.

Im nächsten Verfahrensschritt S3 werden die identifizierten 3D-Daten des selektierten Objektelements in der 3D-Repräsentation mittels Eingabe eines Markierungsbefehls über eine Eingabeschnittstelle markiert. Die Markierung kann beispielsweise ein Hervorheben der entsprechenden 3D-Daten, eine Zwischenspeicherung und/oder ein Auswählen der 3D-Daten in der 3D-Repräsentation sein.

Außerdem kann das Markieren der 3D-Daten in der 3D-Repräsentation des selektierten Objektelements das Speichern einer dem selektierten Objektelement zugeordneten Objektelementinformation umfassen. So können die 3D-Daten aus dem Scan mit weiteren Informationen versehen werden.

Im nächsten Verfahrensschritt S4 wird ein 3D-Computermodell des Objekts aus den 3D-Daten des 3D-Scans, d.h. der 3D-Daten des Objekts, unter Berücksichtigung der Markierung des selektierten Objektelements generiert.

Bei der Generierung des 3D-Computermodells kann die Markierung des selektierten Objektelements berücksichtigt werden, indem die 3D-Daten der 3D-Repräsentation des selektierten Objektelements bei der Generierung des 3D-Computermodells gelöscht werden.

Alternativ kann die Markierung des selektierten Objektelements bei der Generierung des 3D-Computermodells berücksichtigt werden, indem die 3D-Daten der 3D-Repräsentation des selektierten Objektelements für eine nachgelagerte Computersimulation des Objekts gekennzeichnet werden. Beispielsweise können die 3D-Daten derart eine Kennzeichnung/einen Tag erhalten.

Anschließend wird im nächsten Verfahrensschritt S5 das generierte 3D-Computermodell des Objekts ausgegeben.

Optional kann in einem nächsten Verfahrensschritt S6 eine Computersimulation des Objekts auf Basis des 3D-Computermodells ausgeführt werden. Beispielsweise kann eine computergestützte Personenstromsimulation für das Gebäude ausgeführt werden.

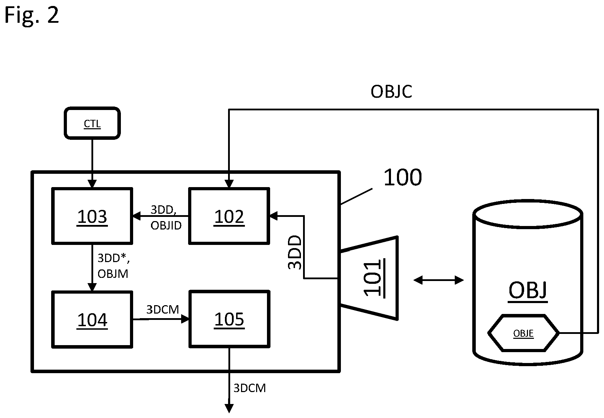

Figur 2 zeigt ein Ausführungsbeispiel einer Vorrichtung 100 zum Generieren eines 3D-Computermodells 3DCM eines Objekts OBJ. Die Vorrichtung 100 kann insbesondere Software- und Hardwarekomponenten, sowie einen Prozessor umfassen.

Die Vorrichtung 100 umfasst einen Scanner 101, wie z.B. einen Laserscanner. Der Scanner 101 ist derart eingerichtet, einen 3D-Scan des Objekts OBJ auszuführen, wobei 3D-Daten 3DD zur Erstellung einer 3D-Repräsentation des Objekts erfasst werden. Beispielsweise ist der Scanner derart eingerichtet, aus den erfassten 3D-Daten 3DD die 3D-Repräsentation des Objekts zu erstellen.

Die Vorrichtung 100 umfasst weiter eine Selektionseinheit 102, die derart eingerichtet ist, einen Objektelementidentifikator OBJID für ein anhand eines vorgegebenen Objektelementmerkmals OBJE selektierten Objektelements OBJE des Objekts OBJ auszugeben. Das Objektelementmerkmal OBJC kann beispielsweise über eine Eingabeschnittstelle der Selektionseinheit 102 bereitgestellt werden. Das Objektelement OBJE kann am realen Objekt OBJ selektiert werden.

Die Vorrichtung 100 umfasst eine Eingabeschnittstelle 103, über die ein Markierungsbefehl CTL eingegeben werden kann. Mittels des Markierungsbefehls CTL und anhand des Objektelementidentifikators OBJID können die 3D-Daten 3DD* in der 3D-Repräsentation des selektierten Objektelements markiert werden. Die markierten 3D-Daten 3DD* sowie die Markierung OBJM der 3D-Daten 3DD* werden anschließend bereitgestellt. Die Markierung OBJM kann dabei auch eine dem selektierten Objektelement zugeordnete Objektelementinformation umfassen.

Die Vorrichtung 100 umfasst weiter einen Modellgenerator 104, der derart eingerichtet ist, ein 3D-Computermodell 3DCM des Objekts anhand des 3D-Scans unter Berücksichtigung der Markierung OBJM des selektierten Objektelements zu generieren. Beispielsweise kann die Markierung OBJM berücksichtigt werden, indem die 3D-Daten 3DD* des selektieren Objektelements bei der Erstellung des 3D-Computermodells 3DCM gelöscht werden. In anderen Worten, aus der 3D-Repräsentation aller vom Scanner 101 erfassten 3D-Daten 3DD wird ein 3D-Computermodell 3DCM erstellt, wobei bei der Erstellung des 3D-Computermodells die 3D-Daten der selektierten Objektelemente z.B. gelöscht, farblich markiert, und/oder gekennzeichnet werden.

Die Vorrichtung 100 umfasst eine Ausgabeeinheit 105, die derart eingerichtet ist, das 3D-Computermodell des Objekts auszugeben. Die Vorrichtung 100 kann beispielsweise mit einem Computer/einer Recheneinheit gekoppelt sein, um eine Computersimulation auf Basis des bereitgestellten 3D-Computermodells auszuführen.

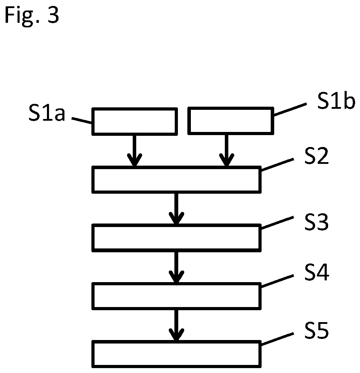

Figur 3 zeigt ein weiteres Ausführungsbeispiel der Erfindung.

Das gezeigte Verfahren basiert insbesondere auf einer Interaktion mit einem real existierenden Objekt, wie z.B. einem Gebäude, während eines 3D-Scans. Während des 3D-Scans muss das Objekt beispielsweise betreten bzw. angefasst werden. Während dieser Interaktion können somit bereits Objektelemente für eine Computersimulation berücksichtigt werden, ohne dass ein aus dem 3D-Scan erstelltes Computermodell danach nochmals bearbeitet werden muss.

Dies soll am Beispiel der Personenstrom-Simulation näher erläutert werden: während des 3D-Scans, Schritt S1a, eines Gebäudes bewegt sich der Erfasser mit dem 3D-Scanner von Raum zu Raum und kann dabei sowohl mit der Umgebung als auch mit dem Scanner interagieren. Dabei werden während des 3D-Scans Objektelemente, wie z.B. Möbel, im Gebäude bestimmt und Objektelementidentifikatoren dieser bestimmten Objektelemente ausgegeben, Schritt S1b. Die Selektion erfolgt anhand von Objektelementmerkmalen, die die entsprechenden Objektelemente charakterisieren.

Für eine spätere Personenstromsimulation sind dabei folgende Eigenschaften wichtig:
- für die Computersimulation unwichtige Objekte müssen entfernt werden,
- mögliche Start- und Zielpunkte von Personen müssen festgelegt werden,
   und/oder
- Kennzeichnung betretbarer Bereiche.

Anhand dieser Eigenschaften können Objektelemente selektiert werden.

Anschließend, im Schritt S2, werden die 3D-Daten in der 3D-Repräsentation der selektierten Objektelemente anhand der Objektelementidentifikatoren identifiziert.

Danach werden die 3D-Daten in der 3D-Repräsentation der selektierten Objektelemente markiert, Schritt S3. Anschließend wird ein 3D-Computermodell des Gebäudes aus den 3D-Daten des 3D-Scans unter Berücksichtigung der Markierung der selektierten Objektelemente erstellt, Schritt S4, und ausgegeben, Schritt S5.

Das Entfernen von Objektelementen kann dabei beispielsweise dadurch gelöst werden, dass einige 3D-Datenpunkte der selektierten Objektelemente durch Berührung oder durch Drücken eines Knopfs am Scanner gekennzeichnet werden. Ausgehend von diesen 3D-Datenpunkten können anschließend die entsprechenden Objektelemente entfernt werden, indem 3D-Datenpunkte so lange aus der 3D-Repräsentation entfernt werden, bis man auf eine zum Fußboden parallele Fläche trifft. Dies würde alle gekennzeichneten Objektelemente entfernen, die auf dem Fußboden oder auf Möbeln (insb. Tischen) stehen. Da sich auch die Personen ausschließlich auf Flächen bewegen, können so fast alle störenden Objektelemente während des 3D-Scans aus der 3D-Repräsentation entfernt werden.

Um Start-/Zielpunkte festzulegen, kann man vor Ort alle möglichen Orte kennzeichnen, an denen sich üblicherweise Personen aufhalten (z.B. Stühle oder Bereiche am Boden). Weiterhin kann man durch eine einfache Interaktion mit dem Scanner auch größere Bereiche festlegen, wo sich Personen aufhalten oder in Zielen verschwinden. Dabei wird ein Startsignal festgelegt, nach dessen Absetzen der Erfasser dann ein Polygon abläuft. Dieses wird automatisch geschlossen, sobald der Ausgangspunkt wieder erreicht ist. Die zum Polygon gehörende Personenanzahl kann dann am Gerät oder per Spracheingabe erfolgen. Weitere Eigenschaften für dieses Polygon (z.B. Personengeschwindigkeit) könnten ebenfalls unmittelbar per Spracheingabe oder am Scanner erfolgen.

Betretbare Bereiche können ohne weitere Nutzerinteraktion bereits beim Ablaufen der Räume mit einem Scanner festgelegt werden. Da der Scanner i.d.R. seine eigene Position im Modell kennt bzw. damit auch die Position des Bedieners, können damit auch die Bereiche eingeschränkt werden, die von Personen betreten werden können. Üblicherweise sind dies alle Punkte im Raum, die mit den o.g. Positionen über eine Bodenfläche zusammenhängen. Diese Bereiche können z.B. über ein herkömmliches Region Growing Verfahren gefunden werden.

Nach Anlegen all dieser Eigenschaften kann unmittelbar eine Personenstromsimulation auf Basis des Modells gestartet werden. Dies kann direkt auf dem Scan-Gerät erfolgen ("on edge"), sodass ggf. auch noch eine Korrektur des Modells vor Ort möglich ist.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Verfahren zum Generieren eines 3D-Computermodells (3DCM) eines Objekts (OBJ) mit den Verfahrensschritten:
- Ausführen (S1a) eines 3D-Scans des Objekts mittels eines Scanners, wobei 3D-Daten (3DD) zur Erstellung einer 3D-Repräsentation des Objekts erfasst werden,
- Ausgeben (S1b) eines Objektelementidentifikators (OBJID) eines selektierten Objektelements (OBJE), wobei das Objektelement (OBJE) anhand eines vorgegebenen Objektelementmerkmals (OBJC) und während der Ausführung des 3D-Scans des Objekts selektiert wird,
- Identifizieren (S2) der 3D-Daten (3DD*) in der 3D-Repräsentation des selektierten Objektelements anhand des Objektelementidentifikators (OBJID),
- Markieren (S3) der 3D-Daten (3DD*) in der 3D-Repräsentation des selektierten Objektelements mittels Eingabe eines Markierungsbefehls (CTL) über eine Eingabeschnittstelle (103),
- Generieren (S4) eines 3D-Computermodells (3DCM) des Objekts aus den 3D-Daten des 3D-Scans unter Berücksichtigung der Markierung (OBJM) des selektierten Objektelements
und
- Ausgeben (S5) des 3D-Computermodells (3DCM) des Objekts.

2. Verfahren nach Anspruch 1, wobei die Markierung (OBJM) des selektierten Objektelements (OBJE) bei der Generierung des 3D-Computermodells berücksichtigt wird, indem die 3D-Daten (3DD*) der 3D-Repräsentation des selektierten Objektelements bei der Generierung des 3D-Computermodells gelöscht werden.

3. Verfahren nach Anspruch 1, wobei die Markierung (OBJM) des selektierten Objektelements bei der Generierung des 3D-Computermodells berücksichtigt wird, indem die 3D-Daten (3DD) der 3D-Repräsentation des selektierten Objektelements bei der Generierung des 3D-Computermodells für eine nachgelagerte Computersimulation des Objekts gekennzeichnet werden.

4. Verfahren nach Anspruch 1 oder 3, wobei das Markieren der 3D-Daten in der 3D-Repräsentation des selektierten Objektelements das Speichern einer dem selektierten Objektelement zugeordneten Objektelementinformation umfasst.

5. Verfahren nach einem der vorhergehenden Ansprüche, wobei sich das Objektelementmerkmal (OBJC) auf eine vorgegebene Anforderung an das Objektelement für eine dem 3D-Scan nachgelagerte Computersimulation des Objekts bezieht.

6. Verfahren nach einem der vorhergehenden Ansprüche, wobei sich das Objektelementmerkmal (OBJC) auf eine vorgegebene Funktion des Objektelements bezieht.

7. Verfahren nach einem der vorhergehenden Ansprüche, wobei der Objektelementidentifikator (OBJID) eine Positionsinformation des Objektelements umfasst.

8. Verfahren nach einem der vorhergehenden Ansprüche, wobei eine Computersimulation des Objekts auf Basis des 3D-Computermodells (3DCM) ausgeführt wird.

9. Verfahren nach einem der vorhergehenden Ansprüche, wobei das Objekt (OBJ) ein Gebäude und die nachgelagerte Computersimulation eine Personenstromsimulation ist.

10. Vorrichtung (100) zum Generieren eines 3D-Computermodells eines Objekts (OBJ), umfassend:
- einen Scanner (101), der derart eingerichtet ist, einen 3D-Scan des Objekts auszuführen, wobei 3D-Daten (3DD) zur Erstellung einer 3D-Repräsentation des Objekts erfasst werden,
- eine Selektionseinheit (102), die derart eingerichtet ist, einen Objektelementidentifikator (OBJID) eines selektierten Objektelements (OBJE) auszugeben, wobei das Objektelement (OBJE) anhand eines vorgegebenen Objektelementmerkmals (OBJC) und während der Ausführung des 3D-Scans des Objekts selektiert wird,
- eine Eingabeschnittstelle (103), die derart eingerichtet ist, die 3D-Daten (3DD*) in der 3D-Repräsentation des selektierten Objektelements anhand des Objektelementidentifikators zu identifizieren und mittels Eingabe eines Markierungsbefehls (CTL) zu markieren,
- einen Modellgenerator (104), der derart eingerichtet ist, ein 3D-Computermodell des Objekts anhand des 3D-Scans unter Berücksichtigung der Markierung (OBJM) des selektierten Objektelements zu generieren,
und
- eine Ausgabeeinheit (105), die derart eingerichtet ist, das 3D-Computermodell des Objekts auszugeben.
